# EUROPEAN PATENT APPLICATION

(11) **EP 4 838 528 A1**
(43) Date of publication of application: **11.11.2026**
(21) Application number: 26154307.8
(22) Date of filing: 27.01.2026
(51) Int. Cl.: G11C 7/10, G11C 11/22

(54) **IN-MEMORY COMPUTING BITCELL, OPERATING METHOD THEREOF, AND SYSTEM INCLUDING SAME**

(30) Priority: 08.05.2025 KR 20250059903
(71) Applicant: Samsung Electronics Co., Ltd., Suwon-si, Gyeonggi-do 16677 (KR)
(72) Inventor: LEE, Changseung, Suwon-si 16678 (KR); PARK, Jaechul, Suwon-si 16678 (KR); JANG, Hyeongseok, Suwon-si 16678 (KR); KANG, Sungchan, Suwon-si 16678 (KR); NAM, Seunggeol, Suwon-si 16678 (KR); OH, Jungyeop, Suwon-si 16678 (KR)
(74) Representative: Elkington and Fife LLP

(57) **Abstract**

An in-memory computing (IMC) bitcell, including: a first word line, a second word line, a first bit line, a second bit line, an input line, and an output line; a first transistor connected to the first word line and the first bit line; a second transistor connected to the second word line and the second bit line; a third transistor connected to the first transistor and the output line; a fourth transistor connected to the second transistor and the output line; a fifth transistor connected to the input line and the output line; and a sixth transistor connected to the fourth transistor and the input line, wherein the third transistor and the fourth transistor are programmable transistors.

## Description

### FIELD OF THE INVENTION

The disclosure relates to in-memory computing (IMC), and more particularly to an in-memory computing bitcell (IMC bitcell), an operating method thereof, and a system including the IMC bitcell.

### BACKGROUND OF THE INVENTION

IMC may refer to a computing architecture technology that reduces data movement and power consumption by utilizing memory as a computing unit. In a digital computation-based IMC method, binary memories such as static random-access memory (SRAM) and computing units such as digital logic gates may be used.

According to some IMC schemes, a circuit may be configured to have a structure in which SRAM cells storing data and multipliers performing computations are combined. Because the number of transistors included in an SRAM cell may generally be approximately six ("6") to ten ("10"), and the number of transistors may be large, there may be a disadvantage in that the circuit area is large and the memory density is low.

The power consumption of SRAM may be divided into two main categories: dynamic power and standby power. For example, dynamic power may be generated during read and write operations, standby power may be power that is continuously consumed by leakage current even while in a standby mode. Due to miniaturization of logic devices, the leakage current and power consumption of SRAM have become issues of concern.

### SUMMARY OF THE INVENTION

Provided are an in-memory computing (IMC) bitcell, an operating method thereof, and a system including same.

Additional aspects will be set forth in part in the description which follows and, in part, will be apparent from the description, or may be learned by practice of the presented embodiments of the disclosure.

In accordance with an aspect of the disclosure, an in-memory computing (IMC) bitcell includes: a first word line, a second word line, a first bit line, a second bit line, an input line, and an output line; a first transistor connected to the first word line and the first bit line; a second transistor connected to the second word line and the second bit line; a third transistor connected to the first transistor and the output line; a fourth transistor connected to the second transistor and the output line; a fifth transistor connected to the input line and the output line; and a sixth transistor connected to the fourth transistor and the input line, wherein the third transistor and the fourth transistor are programmable transistors.

Embodiments relate to a compact in-memory computing (IMC) bitcell that integrates non-volatile storage and logic computation within a single transistor-level cell. A proposed concept is the use of a small number of transistors, including two programmable (preferably ferroelectric) transistors, to store a first input bit (e.g. a weight) and to compute a logic function with a second input bit directly in the memory array, thereby reducing area, data movement and standby power relative to SRAM-based IMC approaches.

A particular contribution may be provided by the specific 6T/7T bitcell topology combining access transistors, input-controlled transistors and a complementary pair of programmable transistors coupled to a common output line. The programmable transistors may be configured with threshold voltages corresponding to a stored first input bit and written sequentially via complementary write voltages on paired bit lines. During computation, complementary read voltages may be applied while the input line biases a further transistor pair, such that the output line resolves to a logic level representing a defined Boolean operation (exemplified as a NAND). This structure achieves both non-volatile storage and deterministic logic evaluation without a separate SRAM cell or external logic gate.

Principal technical effects provided by proposed embodiments mya include a significant reduction in cell area and standby power, together with reduced dynamic energy from minimised data transfer between memory and compute units. By storing the first input bit non-volatily in ferroelectric devices, write operations are infrequent (e.g. weight updates), while repeated compute operations can be performed using only low-energy read and input-line biasing. The complementary read/write scheme improves robustness against disturb and allows reliable discrimination between high-and low-threshold states during computation. Overall, the bitcell functions as a non-volatile logic operator well suited to repeated multiply-accumulate style workloads in Al inference.

The proposed design may be compatible with standard CMOS processes augmented with ferroelectric FET modules, enabling dense arrays without the transistor overhead of conventional SRAM-based IMC. Also proposed are scalable arrays, macros and system integration with column/row control, adder trees and accumulators, facilitating parallel vector or matrix operations. Such architecture is particularly aligned with on-chip Al accelerators, where reduced leakage, high density and localised compute confer system-level power and bandwidth advantage.

Each of the third transistor and the fourth transistor may be configured to store a first input bit.

The input line may be configured to have a voltage that is responsive to a second input bit, and the output line may be configured to have a voltage corresponding to a computation result of the first input bit and the second input bit.

The IMC bitcell may be configured to perform a write operation, and, during the write operation, the first bit line may be configured to have a write voltage that is responsive to the first input bit, and the second bit line may be configured to have a complementary write voltage that is responsive to the first input bit.

The IMC bitcell may be configured to perform a computation operation, and, during the computation operation, the first bit line and the second bit line may be configured to have complementary read voltages.

A gate of the first transistor may be connected to the first word line and a source of the first transistor may be connected to the first bit line, a gate of the second transistor may be connected to the second word line, and a source of the second transistor may be connected to the second bit line, a gate of the third transistor may be connected to a drain of the first transistor, and a drain of the third transistor may be connected to the output line, a gate of the fourth transistor may be connected to a drain of the second transistor and a drain of the fourth transistor may be connected to the output line, a gate of the fifth transistor may be connected to the input line, and a drain of the fifth transistor connected to the output line, and a gate of the sixth transistor may be connected to the input line and a drain of the sixth transistor may be connected to a source of the fourth transistor.

A source of the third transistor may be connected to a power supply node, a source of the fifth transistor may be connected to the power supply node, and a source of the sixth transistor may be connected to ground.

At least one of the programmable transistors may include a ferroelectric field-effect transistor (FeFET).

The third transistor may include a p-type ferroelectric transistor, and the fourth transistor may include an n-type ferroelectric transistor.

The IMC bitcell may further include a seventh transistor, and a drain of the seventh transistor may be connected to the output line.

In accordance with an aspect of the disclosure, a method of operating an in-memory computing (IMC) bitcell, includes: performing a write operation using the IMC bitcell; and performing a computation operation using the IMC bitcell, wherein the IMC bitcell may include a first word line, a second word line, a first bit line, a second bit line, an input line, an output line, a first transistor connected to the first word line and the first bit line, a second transistor connected to the second word line and the second bit line, a third transistor connected to the first transistor and the output line, a fourth transistor connected to the second transistor and the output line, a fifth transistor connected to the input line and the output line, and a sixth transistor connected to the fourth transistor and the input line, wherein the third transistor and the fourth transistor are programmable transistors, wherein the write operation includes: applying a first write voltage corresponding to a first input bit to the first bit line; and applying a second write voltage corresponding to the first input bit to the second bit line, and wherein the computation operation includes: applying a first read voltage to the first bit line, applying a second read voltage to the second bit line, and applying a voltage corresponding to a second input bit to the input line; and providing an output voltage to the output line, wherein the output voltage corresponds to a computation result of the first input bit and the second input bit.

The first write voltage may be applied to the first bit line while the first transistor and the fifth transistor are activated, and while the second transistor and the sixth transistor are deactivated.

The second write voltage may be applied to the second bit line while the first transistor and the fifth transistor are deactivated, and while the second transistor and the sixth transistor are activated.

The applying of the first write voltage to the first bit line and the applying of the second write voltage to the second bit line may be performed sequentially.

The first write voltage may be complementary to the second write voltage, and the first read voltage may be complementary to the second read voltage.

The first input bit may correspond to a weight, and the second input bit may correspond to input data.

The IMC bitcell may further include a seventh transistor having a drain connected to the output line, and the second write voltage may be applied to the second bit line while the first transistor and the fifth transistor are deactivated, and while the second transistor, the sixth transistor, and the seventh transistor are activated.

In accordance with an aspect of the disclosure, a system includes: a processor; and an in-memory computing (IMC) device communicatively connected to the processor, wherein the IMC device may include a plurality of IMC macros, wherein each IMC macro included in the plurality of IMC macros may include an IMC bitcell array including a plurality of IMC bitcells, wherein each IMC bitcell included in the plurality of IMC bitcells includes: a first word line, a second word line, a first bit line, a second bit line, an input line, and an output line; a first transistor connected to the first word line and the first bit line; a second transistor connected to the second word line and the second bit line; a third transistor connected to the first transistor and the output line; a fourth transistor connected to the second transistor and the output line; a fifth transistor connected to the input line and the output line; and a sixth transistor connected to the fourth transistor and the input line, and wherein the third transistor and the fourth transistor are programmable transistors.

The system may further include a memory configured to store input bits of the IMC bitcell array.

The IMC device may further include an adder tree circuit connected to the output line of each IMC bitcell.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 illustrates an in-memory computing (IMC) bitcell according to an embodiment;
FIGS. 2A, 2B, and 2C illustrate examples of a write operation of an IMC bitcell according to embodiments;
FIGS. 2D and 2E illustrate an example of a computation operation of an IMC bitcell according to an embodiment;
FIG. 3 is a flowchart of an operating method of an IMC bitcell according to an embodiment;
FIG. 4 illustrates an IMC bitcell according to an embodiment;
FIG. 5 illustrates an IMC bitcell array according to an embodiment;
FIG. 6 illustrates an IMC macro according to an embodiment;
FIG. 7 is a flowchart of an operating method of an IMC macro according to an embodiment;
FIG. 8 illustrates a system according to an embodiment;
FIGS. 9A and 9B illustrate buffers according to embodiments; and
FIG. 10 illustrates a system according to an embodiment.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of A, B, and C", should be understood as including only A, only B, only C, both A and B, both A and C, both B and C, or all of A, B, and C.

Terms used in the disclosure may be general terms which are used as in consideration of their functions in the disclosure, but this may vary depending on the intention of one of ordinary skill in the art, or the precedent, the emergence of new technologies, etc. In addition, in certain cases, some terms may be arbitrarily selected, and in this case, the meaning is described in detail in the relevant portion of the disclosure. Accordingly, the terms used in the disclosure should be defined based on the meaning of the terms and the descriptions throughout the disclosure, rather than the names of simple terms.

Singular expressions may include plural expressions unless the context clearly indicates otherwise. Plural expressions may encompass singular expressions unless the context explicitly indicates otherwise. For example, "magnons" may refer to either a single magnon or multiple magnons. For example, "waves" may refer to either a wave or multiple waves. Terms used herein, including technical or scientific terms, may have the same meaning as those generally understood by those skilled in the art. In addition, terms including ordinal numbers, such as "first" or "second" used in this disclosure, may be used to describe various components, but the above components should not be limited by the above terms. The terms including ordinal numbers are used only for the purpose of distinguishing one component from another.

Throughout the disclosure, when a part "contains" a component, this may mean that the part may further contain other components, rather than excluding other components, unless otherwise stated. Further, the terms "module" or the like may refer to a unit that processes, or is configured to process, at least one function or operation, which may be implemented in hardware or software or implemented in a combination of hardware and software.

In the disclosure, the term "connect" may refer to an electrical connection or coupling.

Hereinafter, embodiments of the disclosure are described in detail with reference to the accompanying drawings so that those skilled in the art may more easily implement the disclosure. However, the disclosure may be implemented in many different forms, and is not limited to the particular embodiments described herein.

Hereinafter, various embodiments of the disclosure are described with reference to the accompanying drawings.

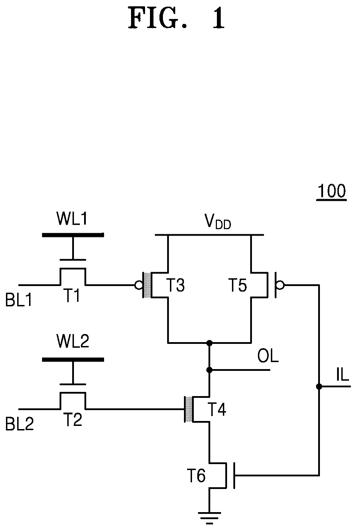

FIG. 1 illustrates an in-memory computing (IMC) bitcell 100 according to an embodiment.

The IMC bitcell 100 includes a first transistor T1, a second transistor T2, a third transistor T3, a fourth transistor T4, a fifth transistor T5, and a sixth transistor T6. In addition, the IMC bitcell 100 includes a first word line WL1, a second word line WL2, a first bit line BL1, a second bit line BL2, an input line IL, and an output line OL.

A gate of the first transistor T1 is connected to the first word line WL1. A source of the first transistor T1 is connected to the first bit line BL1. A drain of the first transistor T1 is connected to a gate of the third transistor T3.

A gate of the second transistor T2 is connected to the second word line WL2. A source of the second transistor T2 is connected to the second bit line BL2. A drain of the second transistor T2 is connected to a gate of the fourth transistor T4.

A drain of the third transistor T3 is connected to the output line OL. Furthermore, the drain of the third transistor T3 is connected to a drain of the fourth transistor T4 and a drain of the fifth transistor T5.

A source of the fourth transistor T4 is connected to a drain of the sixth transistor T6. A drain of the fourth transistor T4 is connected to the output line OL.

A gate of the fifth transistor T5 is connected to the input line IL. A drain of the fifth transistor T5 is connected to the output line OL.

A gate of the sixth transistor T6 is connected to the input line IL.

A source of the third transistor T3 and a source of the fifth transistor T5 may be connected to a power supply node. A source of the sixth transistor T6 may be connected to a ground (e.g., a ground node).

Each of the first transistor T1, the second transistor T2, the fifth transistor T5, and the sixth transistor T6 may be a field effect transistor (FET). For example, the FET may be, or may include, a metal oxide semiconductor FET (MOSFET), but embodiments are not limited thereto.

The first transistor T1 and the second transistor T2 may be n-type transistors.

The third and fourth transistors T3 and T4 may be programmable transistors. In an embodiment, threshold voltages of the third and fourth transistors T3 and T4 may be programmed to correspond to input bits. For example, the third transistor T3 may be programmed to have a high voltage threshold (HVT) (e.g., may be programmed or set to be in a HVT state) in response to an input bit having a value of zero ("0"), or the third transistor T3 may be programmed to have a low voltage threshold (LVT) (e.g., may be programmed or set to be in a LVT state) in response to an input bit having a value of one ("1"). For example, the fourth transistor T4 may be programmed to have a HVT in response to an input bit having a value of zero ("0"), or the fourth transistor T4 may be programmed to have a LVT in response to input bit having a value of one ("1"). For example, each of the third transistor T3 and the fourth transistor T4 may be, or may include, a ferroelectric transistor (FeFET), but embodiments are not limited thereto.

The third transistor T3 and the fourth transistor T4 may have a nonvolatile memory (NVM) function. Although examples are described herein in which the third transistor T3 and the fourth transistor T4 are ferroelectric transistors FeFET, embodiments are not limited thereto, and in some embodiments the third transistor T3 and the fourth transistor T4 may be modified and implemented using other transistors having a nonvolatile memory function.

In the example shown in FIG. 1, the third transistor T3 is a p-type ferroelectric transistor, and the fourth transistor T4 is an n-type ferroelectric transistor. The fifth transistor T5 is a p-type transistor, and the sixth transistor T6 is an n-type transistor. Accordingly, the third to sixth transistors T3 to T6 form a nonvolatile NAND logic gate, and the IMC bitcell 100 forms a nonvolatile operator capable of NAND operation.

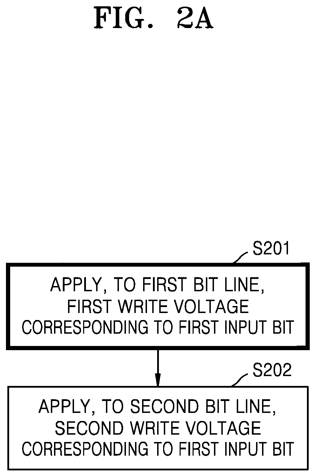

The IMC bitcell 100 may perform a computation of the first input bit and the second input bit through a write operation and a computation operation (i.e., a logic computation). Examples of the write operation and the computation operation are described in detail with reference to FIGS. 2A to 2E.

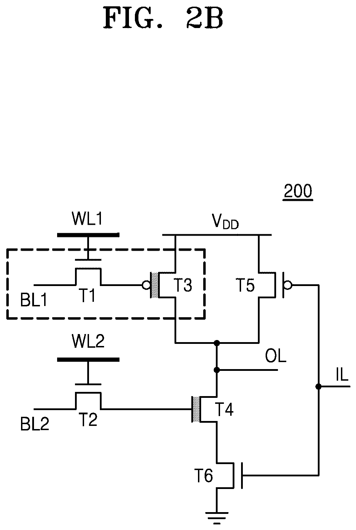

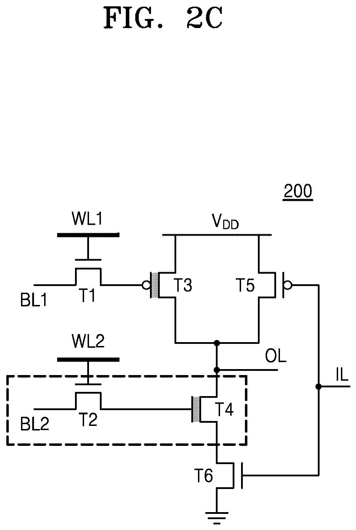

FIGS. 2A, 2B, and 2C illustrate examples of a write operation of an IMC bitcell 200 according to an embodiment.

As shown in FIGS. 2B-2C, the IMC bitcell 200 includes a first transistor T1, a second transistor T2, a third transistor T3, a fourth transistor T4, a fifth transistor T5, and a sixth transistor T6. In addition, the IMC bitcell 200 includes a first word line WL1, a second word line WL2, a first bit line BL1, a second bit line BL2, an input line IL, and an output line OL. In embodiments, the IMC bitcell 200 may correspond to the IMC bitcell 100 discussed above, and redundant or duplicative descriptions of the components of the IMC bitcell 200 may be omitted.

Referring to FIGS. 2A and 2B, when a write operation is performed, at operation S201, the first transistor T1 and the fifth transistor T5 are turned on, and the second transistor T2 and the sixth transistor T6 are turned off. Then, a first write voltage corresponding to a first input bit is applied to the first bit line BL1. According to embodiments, turning on a transistor may be referred to as activating the transistor, and a transistor that is turned on may be referred to as being activated. Similarly, turning off a transistor may be referred to as deactivating the transistor, and a transistor that is turned on may be referred to as being deactivated.

The third transistor T3 may store the first input bit while the first write voltage is applied to the gate. The third transistor T3 may have a polarization direction according to the first write voltage and a threshold voltage according to the polarization direction. In an embodiment, because the third transistor T3 is a p-type ferroelectric transistor, the third transistor T3 may have a HVT based on the first write voltage being +Vw, and may have a LVT based on the first write voltage being -Vw.

The third transistor T3 may store the first input bit by having a polarization direction and a threshold voltage corresponding to the first write voltage. For example, if the third transistor T3 has a LVT, this may indicate that a value of one ("1") may be stored in the third transistor T3, and if the third transistor T3 has a HVT, this may indicate that a value of zero ("0") may be stored in the third transistor T3. Because the ferroelectric transistor maintains the polarization direction even when the power is turned off, the third transistor T3 may store the first input bit as a nonvolatile memory.

At operation S201, because the fifth transistor T5 is turned on and the sixth transistor T6 is turned off, a source and a drain of the third transistor T3 may have a power supply voltage V_{DD}. Accordingly, the third transistor T3 is stably polarized, so that the first input bit may be stably stored in the third transistor T3.

Referring to FIGS. 2A and 2C, when a write operation is performed, at operation S202, the first transistor T1 and the fifth transistor T5 are turned off, and the second transistor T2 and the sixth transistor T6 are turned on. Then, a second write voltage corresponding to the first input bit is applied to the second bit line BL2. Similar to the third transistor T3, because the fourth transistor T4 is a ferroelectric transistor, the fourth transistor T4 may store the first input bit as a nonvolatile memory.

In an embodiment, because the fourth transistor T4 is an n-type ferroelectric transistor, the fourth transistor T4 may have a HVT when the second write voltage is - Vw, and may have a LVT when the second write voltage is +Vw.

The second write voltage may be complementary to the first write voltage. For example, based on the first write voltage being +Vw, the second write voltage may be -Vw, and based on the first write voltage being -Vw, the second write voltage may be +Vw. Accordingly, the fourth transistor T4 may store the same first input bit as the third transistor T3. For example, a value of one ("1") may be stored in the fourth transistor T4 based on the fourth transistor T4 having a LVT, and a value of zero ("0") may be stored in the fourth transistor T4 based on the fourth transistor T4 having a HVT.

Operations S201 and S202 are sequentially performed. Operations S201 and S202 may be performed in the opposite order.

In an embodiment, the write operations of the IMC bitcell 200 at operations S201 and S202 may be expressed as shown in Table 1.

**Table 1**

| | T1 | T2 | T3 | T4 | T5 | T6 |
|---|---|---|---|---|---|---|
| S201: Write 0/1 | BL +Vw/-Vw | OFF | HVT/LVT | - | ON | OFF |
| S202: Write 0/1 | OFF | BL -Vw/+Vw | - | HVT/LVT | OFF | ON |

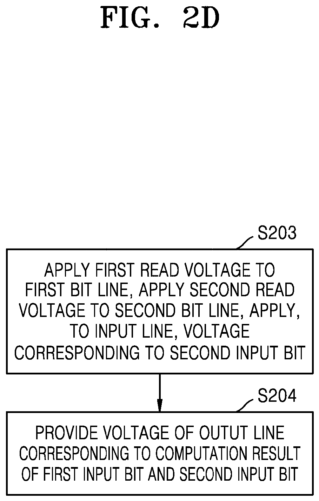

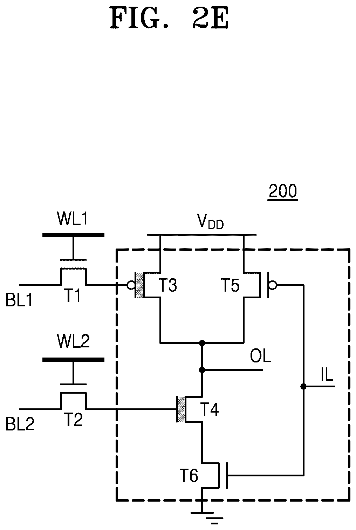

FIGS. 2D and 2E illustrate an example of a computation operation of an IMC bitcell 200 according to an embodiment. When a computation operation is performed, the first transistor T1 and the second transistor T2 are turned on.

At operation S203, a first read voltage is applied to the first bit line BL1. The first read voltage may have a magnitude between a HVT and a LVT. As a non-limiting example, the first read voltage may have an average magnitude of the HVT and the LVT.

When the third transistor T3 has a LVT, the third transistor T3 may be turned off even if the first read voltage is applied. However, when the third transistor T3 has a HVT, the third transistor T3 may be turned on in response to the first read voltage.

In addition, a second read voltage is applied to the second bit line. The second read voltage may have a magnitude between a HVT and a LVT. As a non-limiting example, the second read voltage may have an average magnitude of the HVT and the LVT.

Because the third and fourth transistors T3 and T4 are different in type, the second read voltage may be complementary to the first read voltage. For example, when the first read voltage is -Vr, the second read voltage may be +Vr.

When the fourth transistor T4 has a HVT, the fourth transistor T4 may be turned off even if the second read voltage is applied. However, when the fourth transistor T4 has a LVT, the fourth transistor T4 may be turned on in response to the second read voltage.

In addition, a voltage corresponding to the second input bit is applied to the input line IL. If the second input bit has a value of zero ("0"), a voltage is applied to the input line IL so that the fifth transistor T5 is turned on and the sixth transistor T6 is turned off. When the second input bit has a value of one ("1"), a voltage is applied to the input line IL so that the fifth transistor T5 is turned off and the sixth transistor T6 is turned on.

At operation S204, a voltage of the output line OL corresponding to the computation result of the first input bit and the second input bit is provided. For example, the voltage of the output line OL may represent or indicate the computation result.

According to the description of operation S203, when the first input bit has a value of zero ("0") and the second input bit has a value of zero ("0"), the third transistor T3 and the fifth transistor T5 are turned on, and the fourth transistor T4 and the sixth transistor T6 are turned off. Accordingly, the output line OL is connected to the power supply node to provide the power supply voltage V_{DD} to the output line OL. This may indicate that, as a result of the computation of the first input bit and the second input bit, the output bit is set to a value of one ("1").

When the first input bit has a value of zero ("0") and the second input bit has a value of one ("1"), the third transistor T3 and the sixth transistor T6 are turned on, and the fourth transistor T4 and the fifth transistor T5 are turned off. Accordingly, the output line OL is connected to the power supply node to provide the power supply voltage V_{DD} to the output line OL. This may indicate that, as a result of the computation of the first input bit and the second input bit, the output bit is set to a value of one ("1").

When the first input bit has a value of one ("1") and the second input bit is has a value of zero ("0"), the fourth transistor T4 and the fifth transistor T5 are turned on, and the third transistor T3 and the sixth transistor T6 are turned off. Accordingly, the output line OL is connected to the power supply node to provide the power supply voltage V_{DD} to the output line OL. This may indicate that, as a result of the computation of the first input bit and the second input bit, the output bit is set to a value of one ("1").

When the first input bit has a value of one ("1") and the second input bit has a value of one ("1"), the fourth transistor T4 and the sixth transistor T6 are turned on, and the third transistor T3 and the fifth transistor T5 are turned off. Accordingly, the output line OL is connected to the ground to provide the ground voltage to the output line OL. This may indicate that, as a result of the computation of the first input bit and the second input bit, the output bit is set to a value of zero ("0").

Therefore, at operations S203 and S204, the IMC bitcell 200 may perform a NAND logic computation of the first input bit and the second input bit.

In an embodiment, the computation operation of the IMC bitcell 200 at operations S203 and S204 may be expressed as shown in Table 2.

**Table 2**

| First input bit | Second input bit | T1 | T2 | T3 | T4 | T5 | T6 | Output bit |
|---|---|---|---|---|---|---|---|---|
| 0 | 0 | BL -Vr, WL on | BL +Vr, WL on | ON | OFF | ON | OFF | 1 |
| 0 | 1 | BL -Vr, WL on | BL +Vr, WL on | ON | OFF | OFF | ON | 1 |
| 1 | 0 | BL -Vr, WL on | BL +Vr, WL on | OFF | ON | ON | OFF | 1 |
| 1 | 1 | BL -Vr, WL on | BL +Vr, WL on | OFF | ON | OFF | ON | 0 |

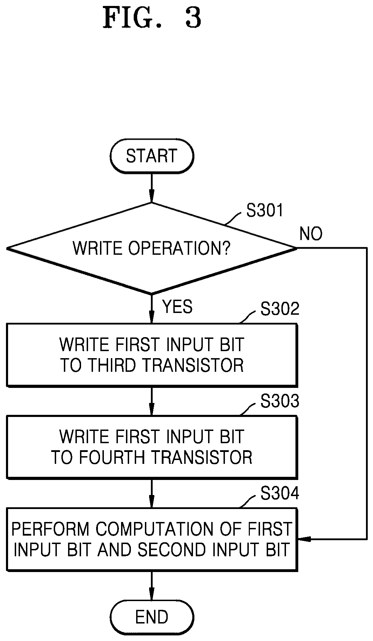

FIG. 3 is a flowchart of an operating method of an IMC bitcell according to an embodiment. Each of the third and fourth transistors of the IMC bitcell may store a first input bit. Because the third transistor and the fourth transistor may be ferroelectric transistors, the stored first input bit may be preserved even when the power is turned off or a computation operation is performed. Therefore, the write operation may be performed only when the first input bit is initially stored, or when the value of the first input bit is changed.

At operation S301, it is determined whether a write operation is to be performed. Operation S301 may be performed by a processor that controls an IMC bitcell. Based on determining to perform the initial write of the first input bit or a change in the value of the first input bit stored in the IMC bitcell, the processor may determine that a write operation is to be performed (Y at operation S301). Based on determining to maintain the value of the first input bit stored in the IMC bitcell, the processor may determine that a write operation is not to be performed (N at operation S301).

If it is determined that the write operation is to be performed, operations S302 and S303 may be performed. Operations S302 and S303 may be sequentially performed in any order. Descriptions with reference to FIGS. 2A and 2B may be applied to operations S302 and S303. For example, operation S302 may correspond to operation S201, and operation S303 may correspond to operation S202 described above. Accordingly, redundant or duplicative description of these operations may be omitted.

After determining that the write operation is not to be performed, or after performing operations S302 and S303, operation S304 is performed. The description with reference to FIG. 2C may be applied to operation S304. For example, operation S304 may correspond to at least one of operation S203 and operation S204 described above. Accordingly, redundant or duplicative description of these operations may be omitted.

In artificial intelligence technology, a large amount of computations of weights and input data may be performed. In these computations, the weights may rarely change (e.g., may change less frequently than the input data). Therefore, when the IMC bitcell operates as shown in FIG. 3, by using the weight for the first input bit and the input data for the second input bit, the computation of the weight and input data may be efficiently performed.

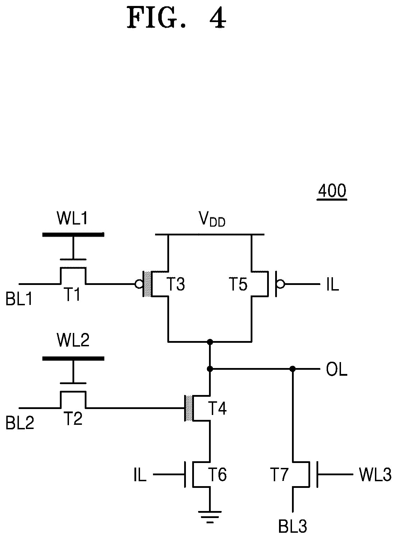

FIG. 4 illustrates an IMC bitcell 400 according to an embodiment. As shown in FIG. 4, the IMC bitcell 400 includes a first transistor T1, a second transistor T2, a third transistor T3, a fourth transistor T4, a fifth transistor T5, and a sixth transistor T6. In addition, the IMC bitcell 40 includes a first word line WL1, a second word line WL2, a first bit line BL1, a second bit line BL2, an input line IL, and an output line OL. In embodiments, these components of the IMC bitcell 400 may correspond to the IMC bitcell 100 discussed above, and redundant or duplicative descriptions of thereof may be omitted.

As shown in FIG. 4, the IMC bitcell 400 includes a first transistor T1, a second transistor T2, a third transistor T3, a fourth transistor T4, a fifth transistor T5, and a sixth transistor T6. In addition, the IMC bitcell 40 includes a first word line WL1, a second word line WL2, a first bit line BL1, a second bit line BL2, an input line IL, and an output line OL. In embodiments, these components of the IMC bitcell 400 may correspond to the IMC bitcell 100 discussed above, and redundant or duplicative descriptions of thereof may be omitted. In an embodiment, the IMC bitcell 400 may further include a seventh transistor T7. The seventh transistor T7 may be a FET. For example, the seventh transistor T7 may be a MOSFET, but embodiments are not limited thereto. The seventh transistor T7 may be an n-type transistor.

A gate of the seventh transistor T7 may be connected to a third word line WL3. A source of the seventh transistor T7 may be connected to a third bit line BL3. In some embodiments, a source of the seventh transistor T7 may be connected to ground. A drain of the seventh transistor T7 may be connected to the drain of the fourth transistor T4

When a write operation of storing the first input bit in the third transistor T3 is performed, the seventh transistor T7 may be turned off. For example, at operation S201 of FIG. 2A, the seventh transistor T7 may be turned off.

When a write operation of storing the first input bit in the fourth transistor T4 is performed, the seventh transistor T7 may be turned on. For example, at operation S202 of FIG. 2B, the seventh transistor T7 may be turned on. In addition, when the source of the seventh transistor T7 is connected to the third bit line BL3, a ground voltage may be supplied to the third bit line BL3. Because the sixth transistor T6 and the seventh transistor T7 are turned on and the first transistor T1 and the fifth transistor T5 are turned off, the source and drain of the fourth transistor T4 may have a ground voltage. Accordingly, because the gate-source voltage and the gate-drain voltage of the fourth transistor T4 are the same, the fourth transistor T4 may be stably polarized and the first input bit may be stably stored in the fourth transistor T4.

According to embodiments, the IMC bitcell may be an integrated memory and computation cell including ferroelectric transistors having a storage function and a computation function for an input bit. Furthermore, the IMC bitcell may be implemented with 6 transistors (6T) (=4T + 2FeFET) or 7 transistors (7T) (=5T + 2FeFET). Therefore, the IMC bitcell may be implemented in a relatively small area with a relatively simple structure, without requiring a separate memory cell such as an SRAM cell. In addition, the standby power may be greatly reduced by storing data in the nonvolatile transistor.

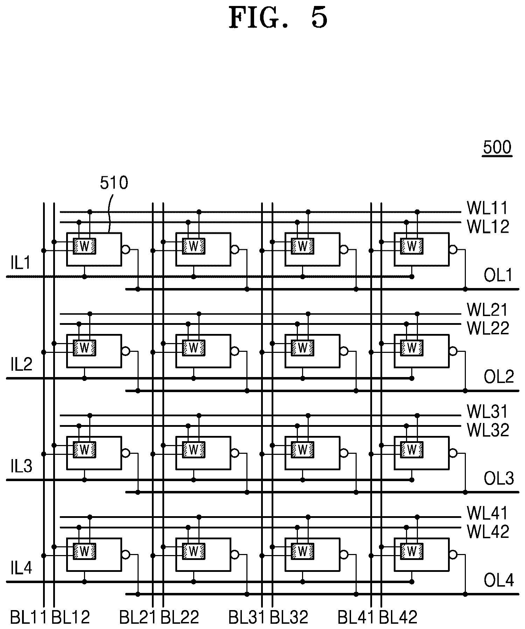

FIG. 5 illustrates an IMC bitcell array 500 according to an embodiment.

The IMC bitcell array 500 includes a plurality of IMC bitcells. In the example shown in FIG. 5, sixteen IMC bitcells, including an IMC bitcell 510, are arranged in a 4x4 arrangement. However, this is only an example, and the size of the IMC bitcell array 500 is not limited thereto.

The above description (e.g., the descriptions of the IMC bitcells 100, 200, and 400) may be applied to each of the IMC bitcell 510 and the other IMC bitcells in the IMC bitcell array 500. Elements marked with W in FIG. 5 indicate a function of storing a first input bit of the IMC bitcell.

IMC bitcells in the same row share same word lines. For example, IMC bitcells in a first row share a first word line WL11 and a second word line WL12, IMC bitcells in a second row share a first word line WL21 and a second word line WL22, IMC bitcells in a third row share a first word line WL31 and a second word line WL32, and IMC bitcells in a fourth row share a first word line WL41 and a second word line WL42.

IMC bitcells in the same row share a same input line. For example, IMC bitcells in the first row share an input line IL1, IMC bitcells in the second row share an input line IL2, IMC bitcells in the third row share an input line IL3, and IMC bitcells in the fourth row share an input line IL4.

IMC bitcells in the same row share a same output line. For example, IMC bitcells in the first row share an output line OL1, IMC bitcells in the second row share an output line OL2, IMC bitcells in the third row share an output line OL3, and IMC bitcells in the fourth row share an output line OL4.

IMC bitcells in the same column share same bit lines. For example, MC bitcells in a first column share a first bit line BL11 and a second bit line BL12, IMC bitcells in a second column share a first bit line BL21 and a second bit line BL22, IMC bitcells in a third column share a first bit line BL31 and a second bit line BL32, and IMC bitcells in a fourth column share a first bit line BL41 and a second bit line BL42.

The IMC bitcell array 500 may be used for vector-to-vector computations, vector-to-matrix computations, or matrix-to-matrix computations. For example, when elements of the first vector (or matrix) are assigned to the first input bits of the IMC bitcells and elements of the second vector (or matrix) are assigned to the second input bits of the IMC bitcells, the IMC bitcell array 500 may perform computations of the first vector (or matrix) and the second vector (or matrix).

The IMC bitcell array 500 may be used for computation of weights and input data of artificial intelligence operations or computations. For example, when the weights are assigned to the first input bits of the IMC bitcells and the input data is assigned to the second input bits of the IMC bitcells, the IMC bitcell array 500 may perform computations of the weights and the input data.

According to a first example, referred to as Example 1, an IMC bitcell array includes a plurality of IMC bitcells, and each IMC bitcell includes: a first word line, a second word line, a first bit line, a second bit line, an input line, and an output line; a first transistor connected to the first word line and the first bit line; a second transistor connected to the second word line and the second bit line; a third transistor connected to the first transistor and the output line; a fourth transistor connected to the second transistor and the output line; a fifth transistor connected to the input line and the output line; and a sixth transistor connected to the fourth transistor and the input line, wherein the third transistor and the fourth transistor may include programmable transistors.

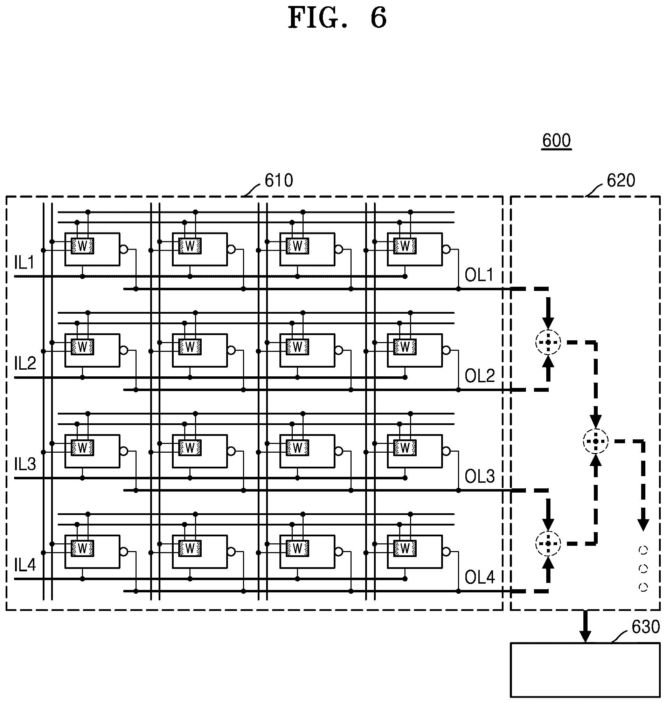

FIG. 6 illustrates an IMC macro 600 according to an embodiment. In embodiments, the IMC macro 600 may be referred to as an IMC macro circuit and an IMC macro structure, but embodiments are not limited thereto.

The IMC macro 600 may include an IMC bitcell array 610 and auxiliary circuitry. In embodiments, the IMC bitcell array 610 may correspond to the IMC bitcell array 500 discussed above, and redundant or duplicative description thereof may be omitted.

In an embodiment, the IMC macro 600 may include a column control circuit and a row control circuit as the auxiliary circuitry.

The column control circuit may control the columns of the IMC bitcell array 610. As a non-limiting example, the column control circuit may include at least one of a column driver and a column decoder. For example, the column control circuit may apply, to a bit line, a write voltage responsive to a first input bit. For example, the column control circuit may apply a read voltage to the bit line.

The row control circuit may control the rows of the IMC bitcell array 610. As a non-limiting example, the row control circuit may include at least one of a row driver and a row decoder. For example, the row control circuit may apply, to an input line, a voltage responsive to a second input bit. For example, the row control circuit may apply a voltage to the word line.

In an embodiment, the IMC macro 600 may include at least one of an adder tree circuit 620 and an accumulator 630 as the auxiliary circuitry. The adder tree circuit 620 may be, or may include, an adder having a structure of an adder tree, and may add output bits of the output lines OL1, OL2, OL3, and OL4 of the IMC bitcell array 610. The accumulator 630 may generate a final computation result by accumulating the addition result of the adder tree circuit 620.

Each IMC bitcell of the IMC bitcell array 610 may store a first input bit in advance. Each IMC bitcell may update its stored first input bit using a write operation. Each IMC bitcell may perform a computation of its stored first input bit and a second input bit input received through an input line using a computation operation.

The IMC bitcell array 610 may perform a computation operation in units of columns. For example, IMC bitcells in the same column of the IMC bitcell array 610 may simultaneously perform a parallel computation. For example, IMC bitcells in the first column of the IMC bitcell array 610 may perform computations of the first and second input bits in parallel and provide the output bits to the adder tree circuit 620. Then, IMC bitcells in the second column of the IMC bitcell array 610 may perform computations of the first and second input bits in parallel and provide the output bits to the adder tree circuit 620. The adder tree circuit 620 may add the output bits for each column, and the accumulator 630 may accumulate the output of the adder tree circuit 620 to generate a final computation result.

According to a second example, referred to as Example 2, an IMC macro includes an IMC bitcell array including a plurality of IMC bitcells and auxiliary circuitry, and each IMC bitcell includes: a first word line, a second word line, a first bit line, a second bit line, an input line, and an output line; a first transistor connected to the first word line and the first bit line; a second transistor connected to the second word line and the second bit line; a third transistor connected to the first transistor and the output line; a fourth transistor connected to the second transistor and the output line; a fifth transistor connected to the input line and the output line; and a sixth transistor connected to the fourth transistor and the input line, wherein the third transistor and the fourth transistor may include programmable transistors.

According to a third example, referred to as Example 3, the auxiliary circuitry of Example 2 may include at least one of a column control circuit, a row control circuit, an adder tree circuit, or an accumulator.

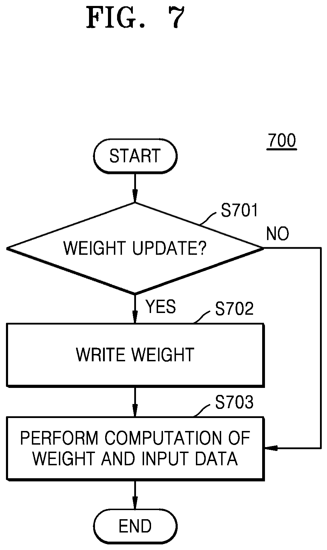

FIG. 7 is a flowchart of an operating method of an IMC macro according to an embodiment.

IMC macros may be used for inference operations or computations associated with artificial intelligence. In detail, the IMC macro may be used for computation of weights used in artificial intelligence inference and input data. In an embodiment, the weights may be previously stored in the IMC macro.

At operation S701, it is determined whether a weight update is to be performed prior to the computation of the weights and input data. Operation S701 may be performed by a processor that controls the IMC macro.

If it is determined that the weight update is necessary, operation S702 is performed. At operation S702, the IMC bitcell to be updated may perform a weight write operation. The weight may be written to the IMC bitcell as a first input bit. The above description may be applied to the write operation. For example, operation S702 may correspond to one or more of operations S201, S202, S302, and S303 described above. Accordingly, redundant or duplicative description of these operations may be omitted.

After it is determined that weight update is not to be performed, or after performing operation S702, operation S703 is performed. The IMC macro may perform a computation operation by using the weights as the first input bits and the input data as the second input bits. The above description may be applied to the computation operation. For example, operation S703 may correspond to one or more of operations S203, S204, and S304 described above. Accordingly, redundant or duplicative description of these operations may be omitted.

In the inference operations or computations associated with artificial intelligence, the weights may rarely change (e.g., may change less frequently than the input data). Therefore, the inference operations or computations associated with artificial intelligence may be efficiently performed by operating the IMC macro as shown in FIG. 7.

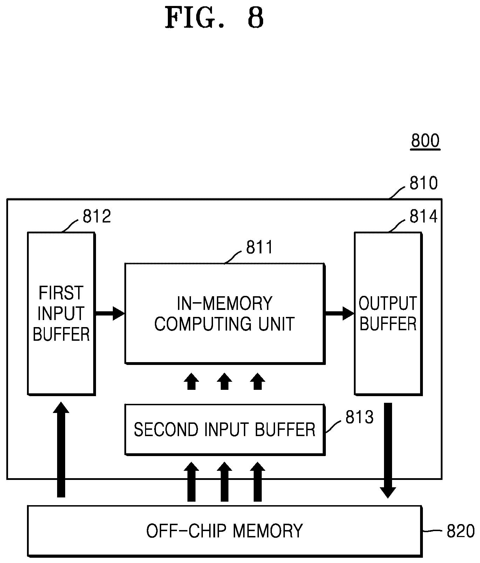

FIG. 8 illustrates a system 800 according to an embodiment.

In an embodiment, the system 800 may include a chip 810 on which on-chip memories of an IMC unit 811, a first input buffer 812, a second input buffer 813, and an output buffer 814 are mounted, and an off-chip memory 820. The IMC unit 811 may include a plurality of IMC macros. The IMC unit 811 may perform a large-scale computation using the plurality of IMC macros. The above description may be applied to each IMC macro included in the plurality of IMC macros. For example, each IMC macro of the plurality of IMC macros included in the IMC unit 811 may correspond to the IMC macro 600 discussed above, and redundant descriptions may be omitted. In embodiments, the IMC unit 811 may be referred to as an IMC device and an IMC chip, but embodiments are not limited thereto.

The off-chip memory 820 may store input bits and/or output bits of the IMC unit 811. As a non-limiting example, the off-chip memory 820 may be a dynamic random access memory (DRAM).

The on-chip memory may temporarily store at least one of input bits and output bits. The first input bits may be provided from the off-chip memory 820 to the IMC unit 811 using the first input buffer 812. The second input bits may be provided from the off-chip memory 820 to the IMC unit 811 using the second input buffer 813. Output bits of the IMC unit 811 may be provided to the off-chip memory 820 using the output buffer 814.

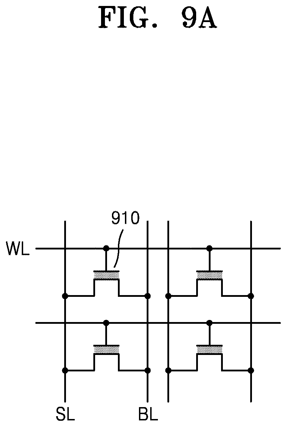

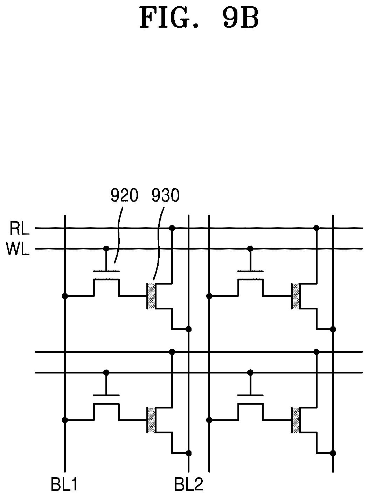

The first input buffer 812 may be implemented using transistors having a nonvolatile memory function. In an embodiment, the first input buffer 812 may include a ferroelectric transistor. Referring to FIGS. 8 and 9A together, in an embodiment, the first input buffer 812 may be configured as a cell array including a single FeFET (1FeFET) memory cell of the ferroelectric transistor 910. The input bit may be stored in each 1FeFET memory cell. In some embodiments, referring to FIGS. 8 and 9B together, in an embodiment, the first input buffer 812 may be configured as a cell array including a single transistor and a single FeFET (1T-1FeFET) memory cell of a transistor 920 and a ferroelectric transistor 930. The input bit may be stored in each 1T-1FeFET memory cell.

As a non-limiting example, at least one of the second input buffer 813 and the output buffer 814 may also be implemented as a transistor having a nonvolatile memory function (e.g., a ferroelectric transistor).

By implementing an on-chip memory using a ferroelectric transistor rather than an SRAM cell, standby power may be greatly reduced and a larger capacity on-chip memory may be implemented in the same area. Therefore, because a large amount of data may be transmitted at once between the off-chip memory 820 and the on-chip memory, and between the IMC unit 811 and the on-chip memory, the power used for data loading may be greatly reduced with a small number of data loading times.

According to a fourth example, referred to as Example 4, an system includes an IMC unit and an on-chip memory, wherein the IMC unit includes a plurality of IMC macros, and each IMC macro includes an IMC bitcell array including a plurality of IMC bitcells, and each IMC bitcell includes: a first word line, a second word line, a first bit line, a second bit line, an input line, and an output line; a first transistor connected to the first word line and the first bit line; a second transistor connected to the second word line and the second bit line; a third transistor connected to the first transistor and the output line; a fourth transistor connected to the second transistor and the output line; a fifth transistor connected to the input line and the output line; and a sixth transistor connected to the fourth transistor and the input line, wherein the third transistor and the fourth transistor may include programmable transistors.

According to a fifth example, referred to as Example 5, the on-chip memory of Example 4 may include an input buffer storing (or configured to store) input bits provided to the IMC bitcell array.

According to a sixth example, referred to as Example 6, the input buffer of Example 5 may be implemented using a ferroelectric transistor.

According to a seventh example, referred to as Example 7, the input buffer of Example 6 may include a 1FeFET memory cell or a 1T-1FeFET memory cell.

According to an eighth example, referred to as Example 8, the IMC unit and the on-chip memory of Example 4 may be mounted on a single chip.

According to a ninth example, referred to as Example 9, the system of Example 4 may further include off-chip memory.

According to a tenth example, referred to as Example 10, the system includes an IMC macro and an on-chip memory, wherein the IMC macro includes an IMC bitcell array including a plurality of IMC bitcells, and each IMC bitcell includes: a first word line, a second word line, a first bit line, a second bit line, an input line, and an output line; a first transistor connected to the first word line and the first bit line; a second transistor connected to the second word line and the second bit line; a third transistor connected to the first transistor and the output line; a fourth transistor connected to the second transistor and the output line; a fifth transistor connected to the input line and the output line; and a sixth transistor connected to the fourth transistor and the input line, wherein the third transistor and the fourth transistor may include programmable transistors.

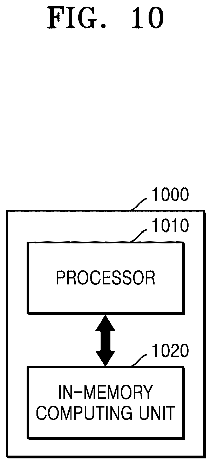

FIG. 10 illustrates a system 1000 according to an embodiment.

In an embodiment, the system 1000 may include a processor 1010 and an IMC unit 1020 communicatively connected to the processor 1010. The IMC unit 1020 may include a plurality of IMC macros. The above description may be applied to each IMC macro included in the plurality of IMC macros. For example, the IMC unit 1020 may correspond to the IMC unit 811, and each IMC macro of the plurality of IMC macros included in the IMC unit 1020 may correspond to the IMC macro 600 discussed above, and redundant descriptions may be omitted. In embodiments, the IMC unit 1020 may be referred to as an IMC device and an IMC chip, but embodiments are not limited thereto.

The system 1000 may be applied to (e.g., at least one of used with, used in, and included in) various electronic devices. As a non-limiting example, the system 1000 may be applied to computing devices, robots, smart TVs, smartphones, medical devices, mobile devices, video display devices, measuring devices, internet of things (IoT) devices, etc. As a non-limiting example, the system 1000 may be applied to an electronic device equipped with an artificial intelligence function.

The processor 1010 may be configured to control the operation of the IMC unit 1020. In addition, the processor 1010 may be configured to process the computation result of the IMC unit 1020. Furthermore, the processor 1010 may be configured to control the operation of the system 1000. For example, the processor 1010 may be, or may include, at least one of a field-programmable gate array (FPGA), a microcontroller (MCU), a central processing unit (CPU), an application processing unit (AP), a digital signal processor (DSP), a graphics processing unit (GPU), a vision processing unit (VPU), or a natural processing unit (NPU), but embodiments are not limited thereto.

As a non-limiting example, the system 1000 may further include at least one of a memory, an input/output module, a security module, a sensor module, or a communication module.

The memory may include the on-chip memory and/or the off-chip memory of FIG. 8. In addition, the memory may be configured to store one or more instructions executed by the processor 1010. For example, memory may be, or may include, cache memory, random access memory (RAM), read only memory (ROM), flash memory, solid state drive (SSD), hard disk drive (HDD), or optical disk drive (ODD), but is not limited thereto.

The sensor module may collect peripheral information of the system 1000. For example, the sensor module may include at least one of a microphone, an imaging device, an image sensor, a light detection and ranging (LIDAR) sensor, an ultrasonic sensor, an infrared sensor, a biosensor, or a touch sensor, but is not limited thereto.

While the programmable transistors are described above primarily with reference to ferroelectric field-effect transistors (FeFETs), the disclosure is not limited thereto. In general, each programmable transistor may be any transistor structure capable of non-volatilely or semi-non-volatilely modulating an effective threshold voltage in response to an applied programming condition. For example, a floating-gate transistor or a charge-trap transistor may be used, in which stored charge in an insulating layer shifts the threshold voltage to represent a stored input bit. As a further example, phase-change FET or resistive-switching FET variants may be employed, in which a change in material phase or resistance state alters the channel conduction characteristics in an analogous manner. In each case, the programmable transistor fulfils the same functional role by providing a stable, distinguishable threshold or conduction state corresponding to a stored first input bit, while remaining readable during a computation operation using an applied read voltage.

The communication module may include various wired or wireless interfaces through which the system 1000 may communicate with an external device. As non-limiting examples, the communication module may include a communication interface capable of connecting to a wired local area network (LAN), a wireless local area network (WLAN) such as wireless fidelity (Wi-fi), a wireless personal area network (WPAN) such as Bluetooth, a wireless universal serial bus (WUSB), Zigbee, near field communication (NFC), radio-frequency identification (RFID), power line communication (PLC), or a mobile cellular network such as 3rd generation (3G), 4th generation (4G), long term evolution (LTE), and 5th generation (5G).

The circuits of the present disclosure may be modified in various forms to perform the operations described above. For example, other types of transistors may be used in other embodiments to execute the functions of the circuits described in embodiments of the present disclosure.

It will be understood by those of ordinary skill in the art that the disclosure described above is for illustration, and those of ordinary skill in the art to which the present disclosure pertains may be easily modified in other specific forms without changing the essential features of the present disclosure. Therefore, it should be understood that the embodiments described above are exemplary and not limiting. For example, each component described as a single type may be distributed and implemented separately, and similarly, components described as being distributed may be implemented in a combined form.

It should be understood that embodiments described herein should be considered in a descriptive sense only, and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. An in-memory computing, IMC, bitcell comprising:
a first word line, a second word line, a first bit line, a second bit line, an input line, and an output line;
a first transistor connected to the first word line and the first bit line;
a second transistor connected to the second word line and the second bit line;
a third transistor connected to the first transistor and the output line;
a fourth transistor connected to the second transistor and the output line;
a fifth transistor connected to the input line and the output line; and
a sixth transistor connected to the fourth transistor and the input line,
wherein the third transistor and the fourth transistor are programmable transistors.

2. The IMC bitcell of claim 1, wherein each of the third transistor and the fourth transistor are configured to store a first input bit, and optionally wherein the input line is configured to have a voltage that is responsive to a second input bit, and the output line is configured to have a voltage corresponding to a computation result of the first input bit and the second input bit.

3. The IMC bitcell of claim 2, wherein the IMC bitcell is configured to perform a write operation, and
wherein, during the write operation, the first bit line is configured to have a write voltage that is responsive to the first input bit, and the second bit line is configured to have a complementary write voltage that is responsive to the first input bit.

4. The IMC bitcell of claim 1 or 2, wherein the IMC bitcell is configured to perform a computation operation, and
wherein, during the computation operation, the first bit line and the second bit line are configured to have complementary read voltages.

5. The IMC bitcell of any preceding claim, wherein a gate of the first transistor is connected to the first word line and a source of the first transistor is connected to the first bit line,
wherein a gate of the second transistor is connected to the second word line, and a source of the second transistor is connected to the second bit line,
wherein a gate of the third transistor is connected to a drain of the first transistor, and a drain of the third transistor is connected to the output line,
wherein a gate of the fourth transistor is connected to a drain of the second transistor and a drain of the fourth transistor is connected to the output line,
wherein a gate of the fifth transistor is connected to the input line, and a drain of the fifth transistor connected to the output line, and
wherein a gate of the sixth transistor is connected to the input line and a drain of the sixth transistor is connected to a source of the fourth transistor.

6. The IMC bitcell of any preceding claim, wherein a source of the third transistor is connected to a power supply node,
wherein a source of the fifth transistor is connected to the power supply node, and
wherein a source of the sixth transistor is connected to ground.

7. The IMC bitcell of any preceding claim, wherein at least one of the programmable transistors comprises a ferroelectric field-effect transistor, FeFET,, and optionally wherein the third transistor comprises a p-type ferroelectric transistor, and
wherein the fourth transistor comprises an n-type ferroelectric transistor.

8. The IMC bitcell of any preceding claim, further comprising a seventh transistor, and
wherein a drain of the seventh transistor is connected to the output line.

9. A system comprising:
a processor; and
an in-memory computing (IMC) device communicatively connected to the processor, wherein the IMC device comprises a plurality of IMC macros,
wherein each IMC macro included in the plurality of IMC macros comprises an IMC bitcell array comprising a plurality of IMC bitcells according to any preceding claim.

10. A method of operating an in-memory computing (IMC) bitcell, the method comprising:
performing a write operation using the IMC bitcell; and
performing a computation operation using the IMC bitcell,
wherein the IMC bitcell comprises a first word line, a second word line, a first bit line, a second bit line, an input line, an output line, a first transistor connected to the first word line and the first bit line, a second transistor connected to the second word line and the second bit line, a third transistor connected to the first transistor and the output line, a fourth transistor connected to the second transistor and the output line, a fifth transistor connected to the input line and the output line, and a sixth transistor connected to the fourth transistor and the input line,
wherein the third transistor and the fourth transistor are programmable transistors,
wherein the write operation comprises:
applying a first write voltage corresponding to a first input bit to the first bit line; and
applying a second write voltage corresponding to the first input bit to the second bit line, and
wherein the computation operation comprises:
applying a first read voltage to the first bit line, applying a second read voltage to the second bit line, and applying a voltage corresponding to a second input bit to the input line; and
providing an output voltage to the output line, wherein the output voltage corresponds to a computation result of the first input bit and the second input bit.

11. The method of claim 10, wherein the first write voltage is applied to the first bit line while the first transistor and the fifth transistor are activated, and while the second transistor and the sixth transistor are deactivated.

12. The method of claim 10 or 11, wherein the second write voltage is applied to the second bit line while the first transistor and the fifth transistor are deactivated, and while the second transistor and the sixth transistor are activated.

13. The method of any of claims 10 to 12, wherein the applying of the first write voltage to the first bit line and the applying of the second write voltage to the second bit line are performed sequentially.

14. The method of any of claims 10 to 13, wherein the first write voltage is complementary to the second write voltage, and
wherein the first read voltage is complementary to the second read voltage.

15. The method of any of claims 10 to 14, wherein the first input bit corresponds to a weight, and
wherein the second input bit corresponds to input data.
